# DEMANDE DE BREVET EUROPEEN

(11) **EP 4 658 002 A1**
(43) Date de publication de la demande: **03.12.2025**
(21) Numéro de dépôt: 25178599.4
(22) Date de dépôt: 23.05.2025
(51) Int. Cl.: H05K 1/02, H05K 9/00, H01L 23/053, H01L 23/552

(54) **CAPOT DE BLINDAGE ELECTROMAGNETIQUE POUR CIRCUIT ELECTRONIQUE**

(30) Priorité: 30.05.2024 FR 2405584
(71) Demandeur: STMicroelectronics International N.V., 1228 Plan-les-Ouates, Geneva (CH)
(72) Inventeur: MASTROMAURO, Nicolas, 38660 LUMBIN (FR); SAXOD, Karine, 73800 PORTE DE SAVOIE (FR)
(74) Mandataire: Cabinet Beaumont

(57) **Abrégé**

La présente description concerne un capot (100) de blindage électromagnétique pour circuit électronique comprenant une face principale (101) et quatre faces latérales (102, 103, 104, 105), une partie renfoncée (110) étant formée au niveau de la base d'une première face latérale (102).

La présente description concerne également un circuit électronique, notamment un dispositif d'émission et/ou de réception optique, comprenant une puce (350) fixée sur une première face principale (301) d'un substrat (300), un tel capot (100) de blindage électromagnétique et un deuxième capot (200) en matériau polymère,
le premier capot (100) et le substrat (300) étant assemblés l'un à l'autre au moyen d'un joint de brasage (400) brasé à la fois sur un plot métallique (310) du substrat (300) et sur au moins une des parois de la partie renfoncée (110).

Le deuxième capot (200) peut être positionné sur ou sous le premier capot (100).

## Description

### Domaine technique

La présente description concerne de façon générale le domaine des circuits électroniques, et plus particulièrement les capots de blindage électromagnétique destinés à protéger les circuits électroniques, notamment ceux incluant des émetteurs de rayonnements lumineux et/ou des récepteurs de rayonnements lumineux.

### Technique antérieure

Certains circuits électroniques comprennent une puce électronique logée dans un boîtier. Un tel boîtier comprend souvent une partie support sur laquelle la puce est fixée, et une partie couvercle recouvrant la puce. Le couvercle est monté sur la partie support. Il est, par exemple, en résine.

Lorsque les puces électroniques comprennent des régions d'émission et de réception de signaux optiques, la partie couvercle comprend, en regard des régions d'émission/réception des éléments transparents pour les longueurs d'ondes des signaux optiques et une paroi interne, délimitant deux cavités, une pour la région d'émission et une pour la région de réception.

De tels circuits électroniques sont, par exemple, utilisés pour réaliser des détecteurs de proximité par mesure de temps de vol (TOF pour "time-of-flight") pour détecter la présence ou l'absence d'un objet situé face au couvercle du boîtier.

Comme de tels circuits électroniques sont sensibles aux ondes électromagnétiques, un blindage électromagnétique doit être ajouté. Pour cela, un capot métallique peut être positionné sur le couvercle. Il peut être solidarisé au substrat support par l'intermédiaire d'un cordon de colle.

Néanmoins, du fait des difficultés de calibrage des cordons, plusieurs inconvénients apparaissent. Il existe un risque que la matière de collage, interposée entre la cloison et le puce réceptrice, flue par capillarité, à l'intérieur du capot, pouvant gêner le bon fonctionnement du composant électronique. En outre, la solidité de la fixation de capot est aléatoire.

### Résumé de l'invention

Il existe un besoin de fournir un circuit électronique comprenant un capot de blindage électromagnétique, le capot présentant une bonne tenue mécanique.

Cet objet est atteint par un circuit électronique, notamment un dispositif d'émission et/ou de réception optique, comprenant une puce fixée sur une première face principale d'un substrat, la première face principale du substrat comportant au moins un plot métallique,
un premier capot de blindage électromagnétique, de préférence en métal, et un deuxième capot, de préférence en matériau polymère, étant superposés et positionnés sur la première face principale du substrat,
le premier capot comprenant une face principale et quatre faces latérales, une partie renfoncée étant formée au niveau de la base d'une première face latérale,
le premier capot et le substrat étant assemblés l'un à l'autre au moyen d'un joint de brasage, positionné dans la partie renfoncée, brasé à la fois sur le plot métallique et sur au moins une des parois de la partie renfoncée.

Selon un mode de réalisation particulier, au moins l'une des autres faces latérales du capot recouvre un des flancs du substrat.

Selon un mode de réalisation particulier, les trois autres faces latérales recouvrent chacune un des flancs du substrat.

Selon un mode de réalisation particulier, le deuxième capot est positionné entre la puce et le premier capot.

Selon un mode de réalisation particulier, le deuxième capot est assemblé mécaniquement au premier capot au moyen d'une couche de colle ou d'adhésif.

Selon un mode de réalisation particulier, le deuxième capot est surmoulé sur le premier capot.

Selon un mode de réalisation particulier, le substrat comprend plusieurs plots métalliques, un joint de brasage étant brasé sur chaque plot métallique et sur au moins une des parois de la partie renfoncée.

Selon un mode de réalisation particulier, le capot couvre au moins 80% de la surface, de préférence au moins 90 % et encore plus préférentiellement au moins 95% de la surface de la première face du substrat.

Cet objet est également atteint par un procédé de fabrication d'un circuit électronique comprenant :
- une première étape au cours de laquelle on positionne le premier capot de blindage électromagnétique sur la première face principale du substrat,
- une deuxième étape au cours de laquelle le premier capot et le substrat sont assemblés l'un à l'autre au moyen d'un ou plusieurs joints de brasage, chaque joint de brasage étant positionné dans la partie renfoncée et brasé à la fois sur un plot métallique et sur au moins une des parois de la partie renfoncée.

Selon un mode de réalisation particulier, le procédé comprend en outre une étape au cours de laquelle un deuxième capot, de préférence en matériau polymère, est assemblé sur la première face principale du premier substrat par l'intermédiaire d'un cordon de colle et une étape au cours de laquelle le premier capot est assemblé sur le deuxième capot au moyen d'une couche de colle ou d'adhésif.

Selon un mode de réalisation particulier, un deuxième capot, en matériau polymère, est surmoulé sur le premier capot avant la première étape.

Selon un mode de réalisation particulier, la deuxième étape est réalisée par projection de brasure.

Cet objet est également atteint par un capot de blindage électromagnétique pour circuit électronique, par exemple en un métal choisi parmi un acier inoxydable ou du cuivre, comprenant une face principale et quatre faces latérales, une partie renfoncée étant formée au niveau de la base d'une première face latérale, la première face latérale ayant, de préférence, une hauteur inférieure à la hauteur des autres faces latérales.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique une vue en coupe et de dessus, d'un circuit électronique selon un mode de réalisation particulier ;
la figure 2 représente, de manière schématique une vue en coupe et de côté d'un circuit électronique, selon un mode de réalisation particulier ;
la figure 3 représente, de manière schématique une vue en coupe et de côté d'un circuit électronique, selon un mode de réalisation particulier ;
la figure 4 représente, de manière schématique une vue en coupe et de côté d'un circuit électronique, selon un mode de réalisation particulier ;
la figure 5 représente, de manière schématique en trois dimensions, une partie d'un circuit électronique, selon un mode de réalisation ;
la figure 6 et la figure 7 sont des clichés photographiques d'une partie du substrat et de la partie renfoncée d'un capot d'un circuit électronique, respectivement, avant et après brasage par jet de brasure, selon un mode de réalisation particulier.

Les différents éléments ne sont pas nécessairement tous à la même échelle afin de rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Par entre X et Y, on entend que les bornes X et Y sont incluses dans la plage de valeurs.

Par onde radiofréquence, on entend une onde électromagnétique dont la fréquence est située entre 3 kHz et 3000 GHz, plus particulièrement entre 3 kHz et 6 GHz, et encore plus particulièrement 100 kHz et 6 GHz.

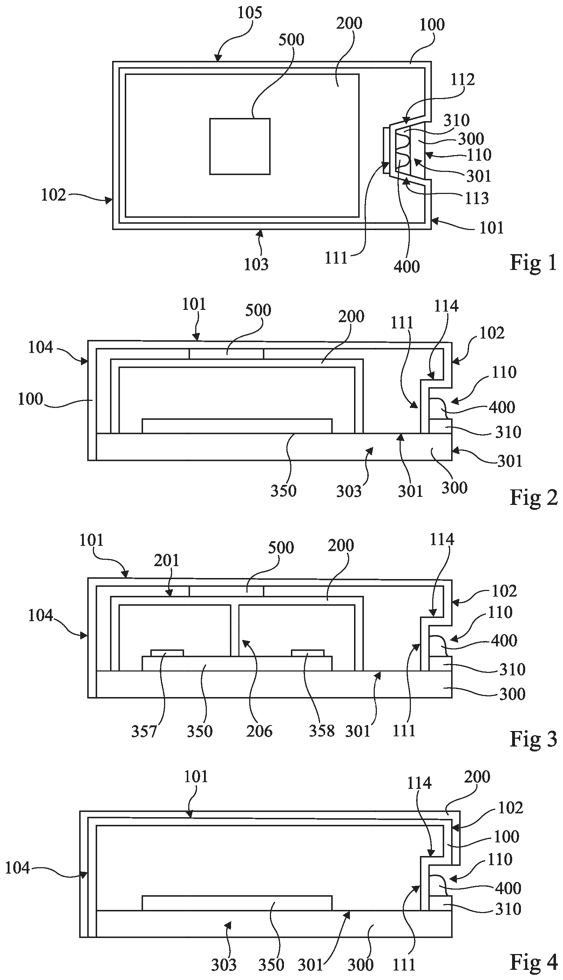

Nous allons décrire en détail les différents éléments du circuit électronique en faisant référence à la figure 1, à la figure 2, à la figure 3, la figure 4 et la figure 5.

Le circuit électronique comprend un substrat support 300 sur lequel est positionnée une puce électronique 350, un premier capot 100 de blindage électromagnétique et un deuxième capot 200 en matériau polymère. Le premier capot 100 et le deuxième capot 200 sont positionnés sur le substrat 300 de manière à protéger la puce 350.

Le premier capot 100 et le deuxième capot 200 sont superposés l'un à l'autre. Le premier capot 100 peut être positionné sur ou sous le deuxième capot 200.

Le substrat support 300 (aussi appelé substrat ou support) comprend une première face principale 301 (face avant), une deuxième face principale 302 (face arrière) sensiblement parallèle à la première face principale 301 et des flancs 303. Les flancs 303 vont de la première face principale 301 à la deuxième face principale 302. Le contour du substrat support est par exemple carré ou rectangulaire.

La zone périphérique de la première face 301 du substrat support 300 est recouverte par au moins un plot 310 ('pad'). De préférence la zone périphérique est recouverte par plusieurs plots 310.

Les plots métalliques 310 peuvent être disposés en retrait par rapport au bord du substrat 300 (figure 1) ou sur le bord du substrat (figures 1 à 5).

Les plots métalliques 310 peuvent être disposés sur deux côtés de la première face afin de fixer le capot 100 sur deux côtés du substrat 300. Les plots métalliques 310 sont, de préférence, disposés sur un seul et même côté de la première face 301.

Les plots 310 sont en un élément pouvant être mouillé par un matériau de brasure afin d'assembler le substrat 300 au premier capot 100. Les plots 310 sont en un métal ou en un alliage de métal. Les plots métalliques 310 sont, par exemple, en cuivre.

Le substrat support 300 est en un matériau diélectrique. Il comprend des connexions électriques (non représentées) allant de la première face principale 301 à la deuxième face principale 302.

Le substrat 300 est un substrat d'interconnexion permettant de relier le circuit électronique à un dispositif extérieur ou à un substrat de type PCB (carte de circuit imprimé ou 'printed circuit board').

La face arrière 302 du substrat support 300 peut être pourvue de plots de connexion électrique pour connecter le circuit électronique à un élément extérieur.

La puce électronique 350 (notée plus simplement puce) 350 est disposée sur le support 300 et plus particulièrement sur la première face principale 301 du substrat support 300. Elle est, par exemple, disposée sur une partie centrale du substrat 300.

La puce 350 est reliée électriquement au réseau de connexions électriques du substrat support 300 par l'intermédiaire d'un élément assurant la connexion électrique, comme des fils ou des billes. Une couche de colle (non représentée) peut être interposée entre la face avant 301 du substrat support 300 et une face arrière de la puce électronique 350.

Selon un mode de réalisation, la puce 350 comprend une partie d'émission optique 357 et une partie de réception optique 358.

La partie photoémettrice 357 est configurée pour émettre un signal lumineux et la partie photoréceptrice 358 est configurée pour détecter un signal lumineux incident. La partie photoémettrice 357 et la partie photoréceptrice 358 sont destinées à coopérer de façon à mesurer une distance par temps de vol du signal lumineux émis puis incident après une réflexion.

Alternativement, deux puces pourraient être utilisées, l'une étant une puce photoémettrice configurée pour émettre un signal lumineux et l'autre puce étant une puce photoréceptrice configurée pour détecter un signal lumineux incident.

Le premier capot 100 joue le rôle de blindage électromagnétique, notamment vis-à-vis des radiofréquences. Le premier capot 100 est, de préférence, un capot métallique. Il est, par exemple, en acier inox (communément appelé acier inoxydable) ou en cuivre. L'acier inoxydable est par exemple l'acier inoxydable SUS430 ou SUS 316L. Le premier capot 100 peut être nickelé (i.e. recouvert de nickel).

Le premier capot 100 comprend une face principale 101 (aussi appelée face avant ou face supérieure) et quatre faces latérales (une première face latérale 102, une deuxième face latérale 103, une troisième face latérale 104 et une quatrième face latérale 105). La troisième face latérale 104 et la première face latérale 102 du capot sont opposées.

Les faces latérales 102, 103, 104, 105 ont une chacune une base (aussi appelée pied) et un sommet. Le sommet se trouve du côté de la face principale 101. La base se situe à l'opposé du sommet.

Une première face latérale 102 a, au niveau de sa base, une partie renfoncée 110 (aussi appelée renfoncement ou encore en termes anglo-saxons 'recessed portion'). Cette partie 110 est retrait par rapport à la première face latérale 102.

La partie renfoncée 110 comprend une première paroi 111 (ou paroi principale), parallèle à la première face latérale 102 du premier capot 100, deux parois latérales 112, 113 et une paroi supérieure 114. Les parois latérales 112, 113 de la cavité 110 peuvent être perpendiculaires à la première paroi 111 ou obliques par rapport à la première paroi 111. Lorsque le premier capot 100 est assemblé au substrat 300, la première face 301 du substrat 300 forme la paroi inférieure de la cavité 110. La base de la première face latérale 102 prend appui sur le substrat 300.

La partie renfoncée 110 forme une cavité ouverte ayant une ouverture au niveau de la première face latérale 102. La partie renfoncée 110 est une partie rentrant dans le capot 100.

Le premier capot 100 peut avoir deux parties renfoncées, une sur la première face latérale 102 et une sur la troisième face latérale 104 par exemple.

La forme et les dimensions de la partie renfoncée 110 dépendent de la forme et de la taille des joints de brasage 400. La partie renfoncée 110 est configurée pour pouvoir loger le ou les joints de brasage 400. Il y a un joint de brasage 400 par plot 310. Par exemple, il y a deux joints de brasage 400 dans la partie renfoncée 110.

En positionnant les joints de brasage 400 dans la partie renfoncée 110, l'effet de flexion du substrat 300 qui pourrait jouer sur la tenue mécanique des joints de brasage 400 (et qui pourrait notamment conduire à la rupture des joints 400) est limité voire nul.

Au moins une partie de la surface de chaque plot 310 est positionnée dans la partie renfoncée 110. Selon une première variante, seule une partie de la surface de chaque plot 310 est positionnée dans la partie renfoncée 110 (figure 1). Selon une deuxième variante, la totalité de la surface de chaque plot 310 (figures 2 à 5) est positionnée dans la partie renfoncée 110.

Une fois assemblées, au moins 80%, de préférence, au moins 90% et encore plus préférentiellement au moins 95% de la surface de la première face 301 du substrat 300 est couverte par le premier capot 100. La portion du substrat 300 non couverte par le blindage électromagnétique est ainsi très faible, ce qui améliore les performances du circuit électronique. Le circuit électronique présente une bonne tenue mécanique, non seulement lors des tests finaux réalisés à l'issue de sa fabrication, mais aussi lors de son fonctionnement.

La première face latérale 102 a une première hauteur. Les deuxième 103, troisième 104 et quatrième 105 faces latérales ont respectivement une deuxième, troisième et quatrième hauteur. La première hauteur est inférieure à au moins l'une de la deuxième, troisième et quatrième hauteur. De préférence, elle est inférieure aux deuxième, troisième et quatrième hauteur. Ainsi, lors du positionnement du capot 100 sur le substrat 300, les deuxième 103, troisième 104 et quatrième 105 faces latérales recouvrent les flancs 303 du substrat support 300. Le blindage électromagnétique obtenu est ainsi particulièrement performant.

De préférence, les faces latérales 103, 104, 105 couvrent au moins 50%, encore plus préférentiellement au moins 80% et de manière encore plus préférentielle la totalité de la hauteur des flancs 303 du substrat 300.

Le premier capot 100 peut comprendre des éléments transparents, par exemple en verre, tels que des lentilles ou des filtres, situés en regard des régions d'émission/réception optique 357, 358 de la puce 350. Les éléments transparents du capot interne sont superposés aux éléments transparents du capot externe 200.

Le filtre optique peut être configuré pour être transparent sélectivement pour une gamme de longueur d'ondes donnée, typiquement la gamme comprenant la longueur d'onde du signal émis par la partie photoémettrice 357, par exemple les infrarouges.

Le premier capot 100 peut être fabriqué par emboutissage.

Le circuit électronique comprend, en plus du premier capot 100, un deuxième capot 200.

Selon un premier mode de réalisation, représenté sur les figures 1 à 3, le deuxième capot 200 est positionné entre la puce 350 et le premier capot 100. Le premier capot 100 recouvre le deuxième capot 200.

Selon ce premier mode de réalisation, le premier capot 100 est le capot externe et le deuxième capot 200 est le capot interne.

La premier capot 200 forme une cavité logeant la puce 350.

Le capot interne 200 comprend une face principale 201 (aussi appelée face avant ou face supérieure) et des faces latérales.

Le capot interne 200 présente un contour inférieur à celui du substrat support 300. Les pieds des faces latérales du deuxième capot 200 sont assemblés mécaniquement sur la première face 301 du substrat 300. L'assemblage peut être réalisé au moyen d'un cordon de colle.

Le capot interne 200 peut comprendre une ou plusieurs parois internes 206 sous forme de plaques (comme par exemple représenté sur la figure 3). Les parois internes 206 sont opaques.

La ou les parois 206 séparent les régions d'émission/réception optique 357, 358 de la puce 350.

La face supérieure du capot interne 200 est assemblé mécaniquement au capot externe 100, par exemple par une couche 500 de colle ou d'adhésif (comme représenté sur les figures1 à 3).

Selon ce mode de réalisation, le deuxième capot 200 peut être en époxy.

Selon un deuxième mode de réalisation, représenté sur les figures 4 à 6, le premier capot 100 est positionné entre le deuxième capot 200 et la puce 350.

Selon ce deuxième mode de réalisation, le premier capot 100 est le capot interne et le deuxième capot 200 est le capot externe.

Le deuxième capot 200 recouvre le premier capot 100 sauf au niveau de la partie renfoncée 110. La partie renfoncée 110 est ainsi libre. Elle est accessible pour pouvoir réaliser l'assemblage du premier capot 100 sur le substrat 100 par brasage. Le deuxième capot 200 a une ouverture traversante au niveau de la partie renfoncée 110 du premier capot 100.

Le deuxième capot 200 peut être surmoulé sur le premier capot 100. Il est, par exemple, en une résine thermo-durcie. Par exemple, il s'agit d'une résine époxy. Le premier capot 100 et le deuxième capot 200 forment un monobloc.

Selon ces deux modes de réalisation, le deuxième capot 200 peut comprendre des éléments transparents, par exemple en verre, tels que des lentilles ou des filtres, situés en regard des régions d'émission/réception optique 357, 358 de la puce 350.

Le filtre optique peut être configuré pour être transparent sélectivement pour une gamme de longueur d'ondes donnée, typiquement la gamme comprenant la longueur d'onde du signal émis par la partie photoémettrice 357, par exemple les infrarouges.

Pour ces différentes variantes et modes de réalisation, le substrat support 300 et le premier capot 100 sont assemblés mécaniquement au moyen de joints de brasage 400.

Plus particulièrement, la phase d'assemblage comprend :
- une première étape de mise en contact du premier capot 100 avec le substrat support 300, et plus particulièrement avec la première face 301 du substrat support 300, qui sert de surface d'appui, et
- une deuxième étape de solidarisation du capot 100 avec le substrat support 300.

La solidarisation est réalisée au moyen d'une étape de brasage. Le matériau de brasage peut être déposé par toute technique de dispense de pâte de brasage ('solder paste dispensing'). De préférence, le brasage est réalisé par projection de brasure ('jet-soldering') au cours duquel on réalise un jet de billes de brasure.

Pour solidariser le capot 100 et le substrat 300, des billes en un matériau de brasage (à l'état fondu) sont projetées sur les surfaces à assembler (ici au niveau de la zone de contact entre les plots de connexion 310 du substrat support 300 et une des parois de la partie renfoncée 110) et, lors du refroidissement du matériau de brasage, des joints de brasage 400 sont formés. Les plots 310 sont positionnés sur le substrat 300 de manière à être en contact avec la base de la paroi principale 111.

Lors du brasage, la paroi principale 111 est mouillée par les billes de brasage.

Le renfoncement permet de contenir la propagation du matériau de brasage. La première surface de la première face latérale 102 n'est pas mouillée par le joint de brasage 400. Le joint de brasage 400 obtenu présente un bon rapport volume/surface. La tenue mécanique des joints de brasage 400 dans le temps est améliorée.

Du côté du substrat support 300, l'extension du joint de brasage 400 est définie par la surface des plots 310 accessible depuis la partie renfoncée 110.

Le diamètre des billes est, par exemple, de 250µm pour des plots de connexion ayant une surface de 250µm x 180µm ou de 250µm x 250µm.

Les billes sont en un matériau de brasage (ou matériau brasable), de préférence, choisi parmi l'étain et un alliage d'étain, comme par exemple SnAg, SnAgCu (noté SAC).

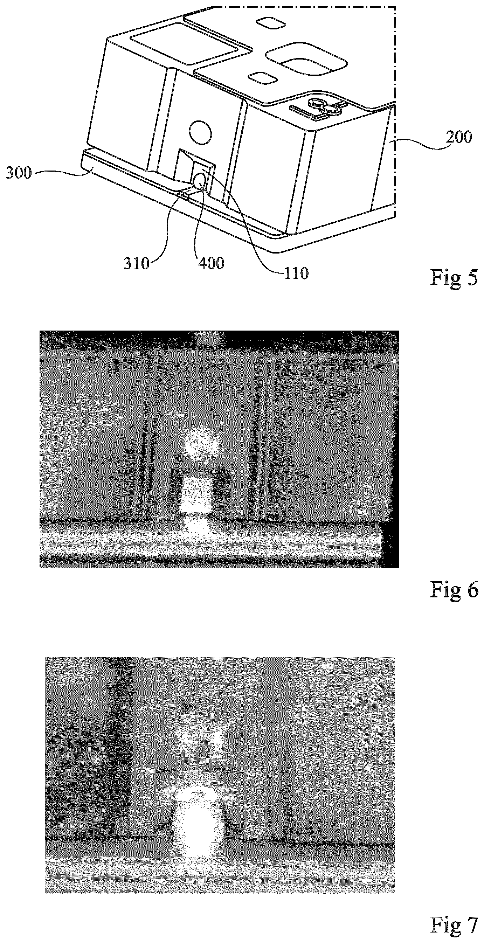

A titre illustratif et non limitatif, la figure 6 montre un circuit électronique dans lequel le deuxième capot 200 est le capot externe. Le capot 200 a une ouverture permettant de réaliser le brasage entre le métal sous-jacent et le plot métallique 310 du substrat 300. Le brasage est réalisé par projection de brasure. Le joint de brasage 400 obtenu présente une bonne tenue mécanique (figure 7).

Avec un tel procédé, il n'y a pas besoin de mettre en œuvre une étape supplémentaire de recuit thermique.

Un tel procédé est simple et peu coûteux à mettre en œuvre.

Le circuit électronique obtenu présente une bonne tenue mécanique et un blindage électromagnétique efficace.

Le circuit électronique est notamment un circuit électronique d'émission et/ou de réception optique et, en particulier, un dispositif TOF de mesure par temps de vol (« time of flight »). La partie photoémettrice 357 est configurée pour émettre un signal lumineux. Le signal sort du capot interne 200 et du capot externe 100. Une surface photosensible de référence de la partie photoréceptrice 358 détecte immédiatement le signal sortant émis par la partie photoémettrice 357, de façon à définir un instant d'émission du signal. Le signal sortant est destiné à être réfléchi ou diffusé sur un élément à l'extérieur du capot externe 100. Le signal réfléchi ou diffusé est dirigé vers la partie photosensible de détection 358. La partie photoréceptrice 358 détecte ainsi un instant de réception du signal réfléchi, et la durée écoulée entre l'instant d'émission et l'instant de réception est directement proportionnelle à la distance séparant le dispositif TOF de l'objet extérieur.

Un tel circuit électronique trouve des applications, notamment, dans le domaine de la téléphonie mobile. Il trouve également des applications dans d'autres domaines industriels.

Le dispositif est, par exemple, destiné à l'industrie automobile.

Le dispositif peut par exemple être utilisé dans le domaine industriel.

Le dispositif peut également être utilisé dans le domaine de l'internet des objets et des maisons intelligentes.

Il peut être utilisé dans les communications en champ proche (ou NFC pour 'near-field communication').

Le dispositif peut également être utilisé dans la mise en œuvre de réseaux 5G, de centres de données et de serveurs.

Le dispositif est, par exemple, destiné à être utilisé dans de l'électronique personnelle, dans les dispositifs de connexions 5G ou plus généralement dans les dispositifs connectés.

Le dispositif est, par exemple, destiné à être utilisé dans des équipements de communication, ou dans des ordinateurs et des périphériques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Circuit électronique, notamment un dispositif d'émission et/ou de réception optique, comprenant une puce (350) fixée sur une première face principale (301) d'un substrat (300), la première face principale (301) du substrat comportant au moins un plot métallique (310),
un premier capot (100) de blindage électromagnétique, de préférence en métal, et un deuxième capot (200), de préférence en matériau polymère, étant superposés et positionnés sur la première face principale (301) du substrat (300),
le premier capot (100) comprenant une face principale (101) et quatre faces latérales (102, 103, 104, 105), une partie renfoncée (110) étant formée au niveau de la base d'une première face latérale (102), la partie renfoncée (110) formant une cavité ouverte dans la première face latérale (102),
le premier capot (100) et le substrat (300) étant assemblés l'un à l'autre au moyen d'un joint de brasage (400), positionné dans la partie renfoncée (110), brasé à la fois sur le plot métallique (310) et sur au moins une des parois de la partie renfoncée (110).

2. Circuit électronique selon la revendication 1, dans lequel au moins l'une des autres faces latérales (103, 104, 105) du capot (100) recouvre un des flancs (303) du substrat (300).

3. Circuit électronique selon l'une des revendications 1 et 2, dans lequel les trois autres faces latérales (103, 104, 105) recouvrent chacune un des flancs (303) du substrat (300).

4. Circuit électronique selon l'une des revendications 1 à 3, dans lequel le deuxième capot (200) est positionné entre la puce (300) et le premier capot (100).

5. Circuit électronique selon la revendication 4, dans lequel le deuxième capot (200) est assemblé mécaniquement au premier capot (100) au moyen d'une couche (500) de colle ou d'adhésif.

6. Circuit électronique selon l'une des revendications 1 à 3, dans lequel le deuxième capot (200) est surmoulé sur le premier capot (100).

7. Circuit électronique selon l'une quelconque des revendications 1 à 6, dans lequel le substrat (300) comprend plusieurs plots métalliques (310), un joint de brasage (400) étant brasé sur chaque plot métallique (310) et sur au moins une des parois de la partie renfoncée (110).

8. Circuit électronique selon l'une quelconque des revendications 1 à 7, dans lequel le capot (100) couvre au moins 80% de la surface, de préférence au moins 90 % et encore plus préférentiellement au moins 95% de la surface de la première face (301) du substrat (300).

9. Procédé de fabrication d'un circuit électronique selon l'une des revendications 1 à 8, le procédé comprenant :
- une première étape au cours de laquelle on positionne le premier capot (100) de blindage électromagnétique sur la première face principale (301) du substrat (300),
- une deuxième étape au cours de laquelle le premier capot (100) et le substrat (300) sont assemblés l'un à l'autre au moyen d'un ou plusieurs joints de brasage (400), chaque joint de brasage (400) étant positionné dans la partie renfoncée (110) et brasé à la fois sur un plot métallique (310) et sur au moins une des parois de la partie renfoncée (110).

10. Procédé selon la revendication 9, comprenant en outre une étape au cours de laquelle un deuxième capot (200), de préférence en matériau polymère, est assemblé sur la première face principale (301) du premier substrat (300) par l'intermédiaire d'un cordon de colle et une étape au cours de laquelle le premier capot (100) est assemblé sur le deuxième capot (200) au moyen d'une couche (500) de colle ou d'adhésif.

11. Procédé selon la revendication 9, dans lequel un deuxième capot (200), en matériau polymère, est surmoulé sur le premier capot (100) avant la première étape.

12. Procédé selon l'une des revendications 9 à 11, dans lequel la deuxième étape est réalisée par projection de brasure.

13. Capot (100) de blindage électromagnétique pour circuit électronique, par exemple en un métal choisi parmi un acier inoxydable ou du cuivre, comprenant une face principale (101) et quatre faces latérales (102, 103, 104, 105), une partie renfoncée (110) étant formée au niveau de la base d'une première face latérale (102), la partie renfoncée (110) formant une cavité ouverte dans la première face latérale (102), la première face latérale (102) ayant, de préférence, une hauteur inférieure à la hauteur des autres faces latérales (103, 104, 105).
